# EUROPEAN PATENT APPLICATION

(11) **EP 4 770 328 A1**
(43) Date of publication of application: **01.07.2026**
(21) Application number: 25218424.7
(22) Date of filing: 25.11.2025
(51) Int. Cl.: H10D 64/01, H10D 64/62, H10D 64/23

(54) **GERMANIUM-RICH METAL CONTACT LAYERS FOR PMOS SOURCE AND DRAIN CONTACTS**

(30) Priority: 26.12.2024 US 202419002375
(71) Applicant: INTEL Corporation, Santa Clara, CA 95054 (US)
(72) Inventor: KARPOV, Ilya V., Portland, OR 97229 (US); BUDREVICH, Aaron A., Portland, OR 97229 (US); METZ, Matthew V., Portland, OR 97229 (US); SEN GUPTA, Arnab, Hillsboro, OR 97123 (US); DEWEY, Gilbert, Beaverton, OR 97006 (US)
(74) Representative: 2SPL Patentanwälte PartG mbB

(57) **Abstract**

Outdiffusion of germanium from silicon-germanium source and drain regions of PMOS (p-channel metal-oxide-semiconductor) field effect transistors into metal contact layers located on the PMOS source and drain regions can reduce the concentration of germanium layer in the silicon-germanium in the vicinity of the silicon-germanium layer-metal contact layer interface. This region of reduced germanium concentration can increase the parasitic contact resistance, which can have a deleterious effect on PMOS transistor performance. Adding germanium to the metal contact layers can reduce or eliminate germanium outdiffusion and prevent parasitic contact resistance increases.

## Description

### BACKGROUND

In PMOS transistors, the source, drain, and channel regions often comprise epitaxial silicon-germanium (SiGe) layers grown on a silicon substrate. The lattice mismatch between silicon germanium and silicon induces compressive strain in the SiGe layer, which enhances the mobility of holes-the primary charge carriers in PMOS transistors-thereby increasing the current-carrying capability of these devices.

### BRIEF DESCRIPTION OF THE DRAWINGS

FIGS. 1A-1C illustrate an example process sequence for forming a metal contact layer comprising germanium on a silicon-germanium epitaxial layer.
FIG. 2 is an example method of forming source and drain contacts with metal contact layers comprising germanium.
FIG. 3 is a top view of a wafer and dies in which any of the source or drain contacts comprising germanium disclosed herein may be included.
FIG. 4 is a cross-sectional view of an integrated circuit structure that may include any of the source or drain contacts comprising germanium disclosed herein.
FIGS. 5A-5D are perspective views of example planar, FinFET, gate-all-around, and stacked gate-all-around transistors.
FIG. 6 is a cross-sectional view of an integrated circuit device assembly that may include any of the contacts comprising a metal contact layer comprising germanium disclosed herein.
FIG. 7 is a block diagram of an example electrical device that may include any of the contacts comprising a metal contact layer comprising germanium.

### DETAILED DESCRIPTION

Source and drain contacts for PMOS (p-channel metal-oxide-semiconductor) field effect transistors are typically made to silicon-germanium (SiGe) layers grown epitaxially on a silicon substrate. The lattice mismatch between silicon germanium and silicon induces compressive strain in the SiGe layer, which enhances the mobility of holes, thereby increasing the current-carrying capability of PMOS transistors. Formation of a source or drain metal contact to a PMOS source or drain region involves the formation of a metal contact layer on a SiGe layer and then filling a contact trench with a fill metal. Subsequent thermal processing experienced by the contacts (e.g., downstream annealing steps) can cause germanium to diffuse out of the SiGe layer and into the metal contact layer. Empirical results indicate that this outdiffusion of germanium can create a germanium "depletion region" in the SiGe layer near the SiGe layer-metal contact layer interface in which the reduce the germanium concentration has been reduced by an order of magnitude or more due to the diffusion. This can cause an increase in the parasitic contact resistance of PMOS source and drain contacts, which can negatively impact the performance of PMOS transistors.

Described herein are technologies pertaining to contacts comprising metal contact layers that include germanium that contact to PMOS source and drain regions. By reducing the germanium concentration gradient between the SiGe layer and the metal contact layer, the presence of germanium in the metal contact layer can prevent or reduce the diffusion of germanium out of the SiGe layer and into the metal contact layer during subsequent thermal processing. These metal contact layers thus can provide the advantage of preventing an increase in parasitic source and drain contact resistance.

The metal contact layer can comprise titanium, molybdenum, or a high work function metal. In some embodiments, the metal contact and SiGe layers comprise boron or another p-type dopant. The p-type dopant used in the metal contact layer can be the same as or different from the p-type dopant used in the SiGe layer (e.g., boron). The metal contact layer can comprise the same p-type dopant as used in the SiGe layer to prevent out-diffusion of the p-type dopant from the SiGe layer into the metal contact layer. The metal contact layers comprising germanium can be formed by sputtering, atomic layer deposition (ALD), chemical vapor deposition (CVD) or other suitable processes. Formation of metal contact layers by sputtering can comprise the co-sputtering of multiple targets, one that comprises the contact metal and the other comprising germanium.

In the following description, specific details are set forth, but embodiments of the technologies described herein may be practiced without these specific details. Well-known circuits, structures, and techniques have not been shown in detail to avoid obscuring an understanding of this description. Phrases such as "an embodiment," "various embodiments," "some embodiments," and the like may include features, structures, or characteristics, but not every embodiment necessarily includes the particular features, structures, or characteristics.

Some embodiments may have some, all, or none of the features described for other embodiments. "First," "second," "third," and the like describe a common object and indicate different instances of like objects being referred to. Such adjectives do not imply objects so described must be in a given sequence, either temporally or spatially, in ranking, or in any other manner.

The term "connected" may indicate elements are in direct physical or electrical contact with each other and "coupled" may indicate elements cooperate or interact with each other, but they may or may not be in direct physical or electrical contact. Furthermore, the terms "comprising," "including," "having," and the like, as used with respect to embodiments of the present disclosure, are synonymous.

Terms modified by the word "substantially" include arrangements, orientations, spacings, or positions that vary slightly from the meaning of the unmodified term. For example, layers, faces, or features that are referred to as being substantially parallel can refer to layers, faces, or features that are within a few degrees of being parallel with each other; layers, faces, or features that are referred to as being substantially perpendicular to each other can refer to features that are within +/- 15 degrees of being perpendicular to each other; and atomic composition percentages referred to as being substantially constant can vary within +/- 10% of the recited percentage. Further, recited numerical or percentage values (including those recited as starting and ending values for a range of numbers or percentages) preceded by the word "about" includes numerical or percentage values within +/- 10% of the recited numerical or percentage value.

As used herein, the phrase "located on" in the context of a first layer or component located on a second layer or component refers to the first layer or component being directly physically attached to the second part or component (no layers or components between the first and second layers or components) or physically attached to the second layer or component with one or more intervening layers or components. As used herein, the term "adjacent" refers to layers or components that are arranged next to each other (e.g., side-by-side, top and bottom).

Certain terminology may also be used herein for the purpose of reference only, and thus are not intended to be limiting. For example, terms such as "upper," "lower," "above," "below," "bottom," and "top" refer to directions in the Figures to which reference is made. Terms such as "front," "back," "rear," and "side" describe the orientation and/or location of layers, components, portions of components, etc., within a consistent but arbitrary frame of reference, which is made clear by reference to the text and the associated Figures describing the layers, component, portions of components, etc. under discussion. Such terminology may include the words specifically mentioned above, derivatives thereof, and words of similar import.

As used herein, the term "integrated circuit component" refers to a packaged or unpacked integrated circuit product. A packaged integrated circuit component comprises one or more integrated circuit dies mounted on a package substrate with the integrated circuit dies and package substrate encapsulated in a casing material, such as a metal, plastic, glass, or ceramic. In one example, a packaged integrated circuit component contains one or more processor units mounted on a substrate with an exterior surface of the substrate comprising a solder ball grid array (BGA). In one example of an unpackaged integrated circuit component, a single monolithic integrated circuit die comprises solder bumps attached to contacts on the die. The solder bumps allow the die to be directly attached to a printed circuit board. An integrated circuit component can comprise one or more of any computing system component described or referenced herein or any other computing system component, such as a processor unit (e.g., system-on-a-chip (SoC), processor core, graphics processor unit (GPU), accelerator, chipset processor), I/O controller, memory, or network interface controller.

As used herein, the phrase "electrically coupled" refers to the presence of one or more electrically conductive paths between components that are recited as being electrically coupled.

Reference is now made to the drawings, which are not necessarily drawn to scale, wherein similar or same numbers may be used to designate same or similar parts in different figures. The use of similar or same numbers in different figures does not mean all figures including similar or same numbers constitute a single or same embodiment. Like numerals having different letter suffixes may represent different instances of similar components. The drawings illustrate generally, by way of example, but not by way of limitation, various embodiments discussed in the present document.

In the following description, for purposes of explanation, numerous specific details are set forth in order to provide a thorough understanding thereof. It may be evident, however, that the novel embodiments can be practiced without these specific details. In other instances, well-known structures and devices are shown in block diagram form in order to facilitate a description thereof. The intention is to cover all modifications, equivalents, and alternatives within the scope of the claims.

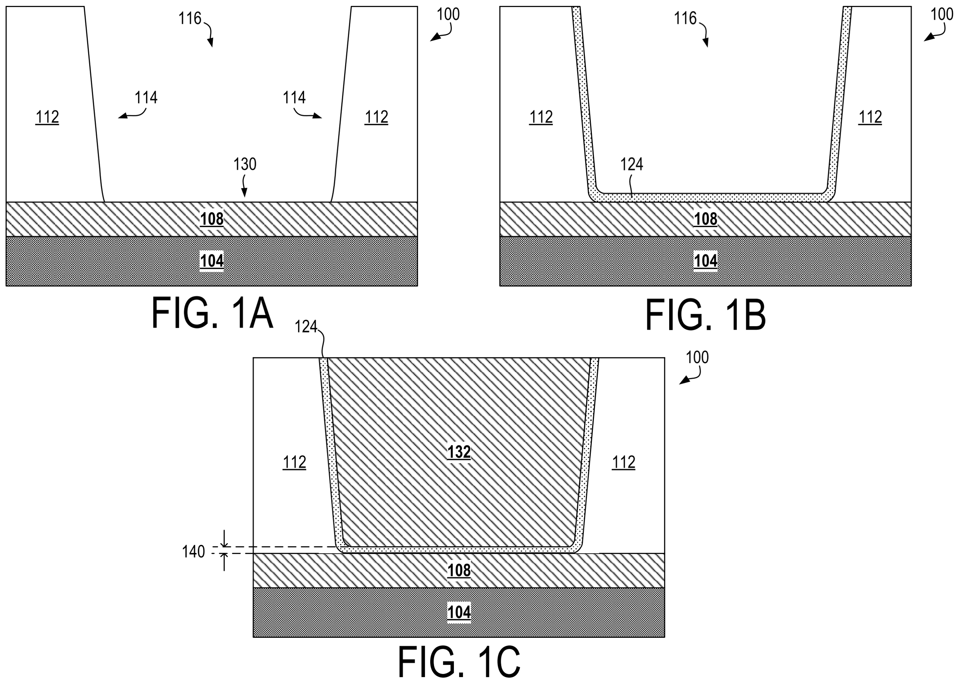

FIGS. 1A-1C illustrate an example process sequence for forming a metal contact layer comprising germanium on a silicon-germanium epitaxial layer. FIG. 1A illustrates a structure 100 comprising a substrate 104, a silicon-germanium layer (SiGe layer 108), and regions of an isolation layer (isolation regions 112) A trench 116 has been formed in the isolation layer by a suitable etch process. The substrate 104 can comprise silicon and can be a bulk silicon wafer, a silicon-on-insulator wafer, or another suitable substrate. As the SiGe layer 108 is part of a PMOS transistor, it comprises one or more p-type dopants, such as boron, indium, or gallium. In some embodiments, the SiGe layer 108 can be an epitaxially grown layer with doping of the SiGe layer 108 occurring during epitaxial growth of the layer (e.g., in situ doping).

The isolation regions 112 can comprise any suitable nitride or oxide, such as silicon dioxide (SiO₂, which is a material that comprises silicon and oxygen), carbon-doped silicon dioxide (C-doped SiO₂, also known as CDO or organosilicate glass, which is a material that comprises silicon, oxygen, and carbon), fluorine-doped silicon dioxide (F-doped SiO₂, also known as fluorosilicate glass, which is a material that comprises fluorine, silicon, and oxygen), hydrogen-doped silicon dioxide (H-doped SiO₂, which is a material that comprises silicon, oxygen, and hydrogen), or silicon nitride (SiₓN_{y} (e.g., Si₃N₄), which is a material that comprises silicon and nitrogen).

FIG. 1B illustrates the structure 100 after formation of a metal contact layer 124. A first portion of the metal contact layer 124 is located on the SiGe layer 108 and second portions of the metal contact layer 124 are located on sidewalls 114 of the isolation regions 112. The metal contact layer 124 comprises germanium and a metal, such as titanium, tantalum, niobium, molybdenum, tungsten, nickel, ruthenium, platinum, gold, palladium, iridium, or another suitable metal or alloy. In some embodiments, the metal contact layer 124 further comprises a p-type dopant. The p-type dopant can be the same as or different from the p-type dopant used in the SiGe layer 108. Thus, in some embodiments, the metal contact layer 124 can comprise titanium, germanium, and boron and the SiGe layer 108 can comprise boron. In other embodiments, the metal contact layer 124 can comprise molybdenum, germanium, and boron and the SiGe layer 108 can comprise boron. In some embodiments, the portion of the metal contact layer 124 located on the SiGe layer 108 can have a thickness 140 of about 10 nanometers or less, about 5 nanometers or less, or about 3 nanometers or less. In some embodiments, the thickness of the portions of the metal contact layer 124 located on the sidewalls 114 of the isolation regions 112 can be different than the thickness of the portion of the metal contact layer 124 located on the SiGe layer 108. In some embodiments, the metal contact layer 124 is selectively deposited on a surface 130 of the SiGe layer 108 and does not comprise portions that are located on the sidewalls 114.

The metal contact layer 124 can be formed by chemical vapor deposition (CVD), plasma-enhanced chemical vapor deposition (PECVD), atomic layer deposition (ALD), physical vapor deposition (e.g., sputtering), or another suitable deposition or thin film formation process. In some embodiments of forming the metal contact layer, where the metal contact layer is formed via sputtering, a single sputtering target comprising a metal contact layer metal (any of the metals disclosed herein as being used to form a metal contact layer) and germanium is used. In some embodiments, the target can further comprise boron.

In other embodiments where the metal contact layer is formed via sputtering, the metal contact layer is formed via co-sputtering of two targets, with one of the sputtering targets comprising a metal contact layer metal and the other sputtering target comprising germanium. In some embodiments, either of the targets used in a co-sputtering process to form the metal contact layer can comprise boron or another p-type dopant. Any sputtering target comprising germanium can comprise about 10% to about 50% germanium by weight. In embodiments where sputtering is used to form the metal contact layer and the target comprises boron, the target can comprise from 5% to about 20% or from 5% to about 50% boron by weight. In embodiments where the metal contact layer is co-sputtered, the metal contact layer can be formed by sputtering both targets (one comprising a metal, one comprising germanium) to form a first sub-layer and then sputtering just the target comprising the metal to form a second sub-layer that does not comprise germanium.

In some embodiments of metal contact layer formation, the metal contact layer is formed via atomic layer deposition, the atomic layer deposition process comprises alternately forming sub-layers comprising germanium with sub-layers comprising a metal contact layer metal.

In some embodiments of metal contact layer formation, where the metal contact layer is formed via chemical vapor deposition, the metal contact layer can be formed with a substantially constant atomic composition percentage (atomic percentage) of germanium across the metal contact layer. In other embodiments, the metal contact layer can be formed with a germanium concentration that generally reduces across the metal contact layer from the SiGe layer-metal contact layer interface to the face of the metal contact layer distal to the SiGe layer-metal contact layer interface. For example, the concentration of the germanium precursor (e.g., germane (GeH₄)) in the reaction chamber can be reduced gradually during the metal contact layer formation process to create a germanium concentration gradient across the metal contact layer. In other examples of metal contact layer formation via a chemical vapor deposition process, during a first phase of the chemical vapor deposition process, a first germanium precursor concentration can be used to form a metal contact layer sub-layer comprising a first atomic percentage of germanium. In a second phase of the chemical vapor deposition process, a second germanium precursor concentration that is lower than the first germanium precursor concentration can be used to form a second sub-layer having a second atomic percentage of germanium that is lower than the first atomic percentage of germanium. In some embodiments, there is no germanium precursor used in the formation of the second sub-layer, and the second metal contact layer sub-layer does not comprise germanium.

In some embodiments of metal contact layer formation, the formation of a metal contact layer can comprise forming a first sub-layer comprising a metal and germanium and forming a second sub-layer that does not comprise germanium. In such embodiments, a thickness of the first sub-layer can be less than about 5 nm, 4 nm, 3 nm, 2 nm, or 1 nm. A metal contact layer having a germanium atomic percentage that generally reduces (e.g., gradually, in one or more "steps") across the metal contact layer from the SiGe layer-metal contact layer interface to the face of the metal contact layer distal to the SiGe layer-metal contact layer interface can still reduce or prevent germanium outdiffusion from the SiGe layer.

FIG. 1C illustrates the structure 100 after the trench 116 has been filled by a metal (fill metal 132). The fill metal 132 can be formed by chemical vapor deposition (CVD), plasma-enhanced chemical vapor deposition (PECVD), physical vapor deposition (e.g., sputtering), or other suitable fill process. The fill metal 132 can comprise tungsten, cobalt, titanium, gold, aluminum, molybdenum, chromium, nickel, or another suitable metal or alloy. In some embodiments, a barrier layer to protect the metal contact layer 124 from oxygen and other contaminants can be formed on the metal contact layer 124 before fill of the trench 116 by the fill metal 132. The barrier layer is positioned between the metal contact layer 124 and the fill metal 132 and can comprise tantalum (Ta), tantalum nitride (which is a material that comprises titanium and nitrogen (e.g., TaN, Ta₂N, Ta₃N₅)), indium oxide (In₂O₃, which is a material that comprises indium and oxygen), tungsten nitride (which is a material that comprises tungsten and nitrogen (e.g., W₂N, WN, WN₂), titanium nitride (TiN, which is a material that comprises titanium and nitrogen), ruthenium, or another suitable material.

As a result of forming a metal contact to a PMOS source or drain region wherein the metal contact comprises a metal contact layer comprising germanium, the germanium concentration reduction in the vicinity of the SiGe layer-metal contact layer interface may be less than in metal contact embodiments in which the metal contact layers do not comprise germanium. The germanium atomic composition percentage profiles at the SiGe layer-metal contact layer interface or in the vicinity thereof, after subsequent thermal processing of an integrated circuit structure comprising the metal contacts described herein, can have a profile as described in the following examples.

In a first example, the atomic percentage of germanium in the SiGe layer at the SiGe layer-metal contact layer interface is no less than the maximum atomic percentage of germanium in the SiGe layer taken along a line from the SiGe layer-metal contact layer interface to a point about 20 nanometers into the SiGe layer. In a second example, the atomic percentage of germanium in the SiGe layer at the SiGe layer-metal contact layer interface is no less than 80% of this maximum germanium atomic percentage.

In a third example, the atomic concentration of germanium at the SiGe layer-metal contact layer interface is greater than 5.0 x 10²¹ cm³, 7.5 x 10²¹ cm⁻³, or 1.0 x 10²² cm⁻³. In a third example, the minimum atomic percentage of germanium along a line taken from a point about three nanometers into the SiGe layer from the SiGe layer-metal contact layer interface to a point about three nanometers into the metal contact layer from the SiGe layer-metal contact layer is no less than about 50% of the maximum atomic percentage of germanium taken along the same line. In variations of the third example, the line used for determining the minimum and maximum germanium atomic percentages can extend a distance other than three nanometers into the SiGe layer and metal contact layers from the SiGe layer-metal contact layer interface, such as 1 nm, 2 nm, 5 nm, 10 nm, 15 nm, or 20 nm. In other variations of the third example, the minimum atomic percentage of germanium can be a percentage of the maximum atomic percentage, other than 30%, such as 40%, 60%, 70%, 80%, or 90%. In still other variations of the third example, the minimum atomic percentage of germanium can be within about an order of magnitude of the maximum atomic percentage of germanium.

In a fourth example, the minimum atomic percentage of germanium in the metal contact layer taken along a line taken from the SiGe layer-metal contact layer interface to a face of the metal contact layer located opposite to the SiGe layer-metal contact layer interface is greater than about 50% of the maximum atomic percentage of germanium taken along this line through the metal contact layer. In a variation of the fourth example, the minimum atomic percentage of germanium along this line through the metal contact layer can be within about an order of magnitude of the maximum atomic percentage of germanium across this line.

In a fifth example, a maximum atomic percentage of germanium in the metal contact layer taken a long a line across the metal contact layer is greater than a maximum atomic percentage of germanium in the SiGe layer taken along a line from the SiGe layer-metal contact layer interface to a point 20 nanometers into the SiGe layer.

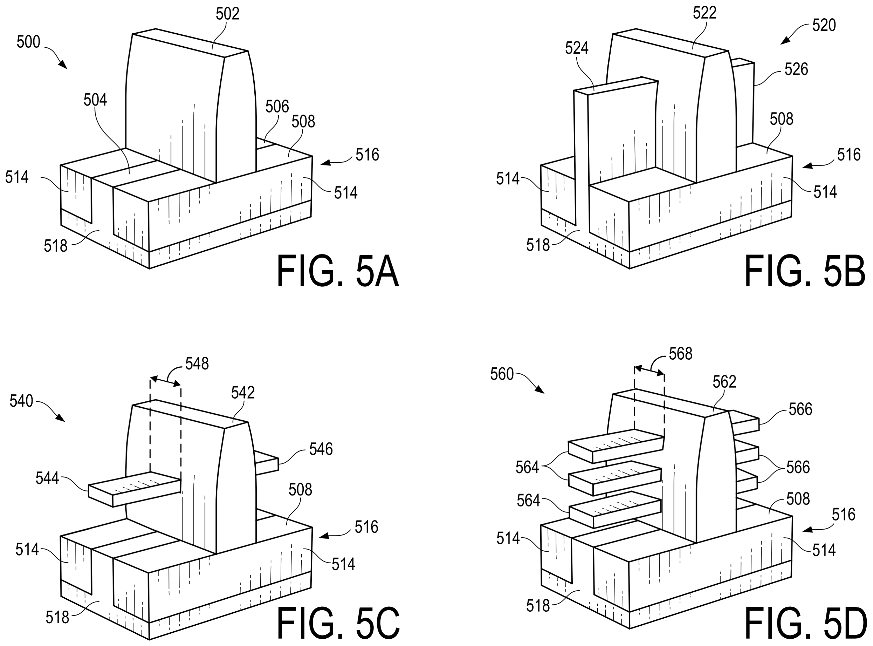

The PMOS source and drain contacts comprising metal contact layers comprising germanium (and methods for forming the same) disclosed herein can be used to contact SiGe layers that are part of a source or drain region of any type of transistor, such as a planar FET, a FinFET, a gate-all-around FET (GAAFET), or stacked GAAFET (e.g., transistors 500, 520, 540, and 560 illustrated FIGS. 5A-5D).

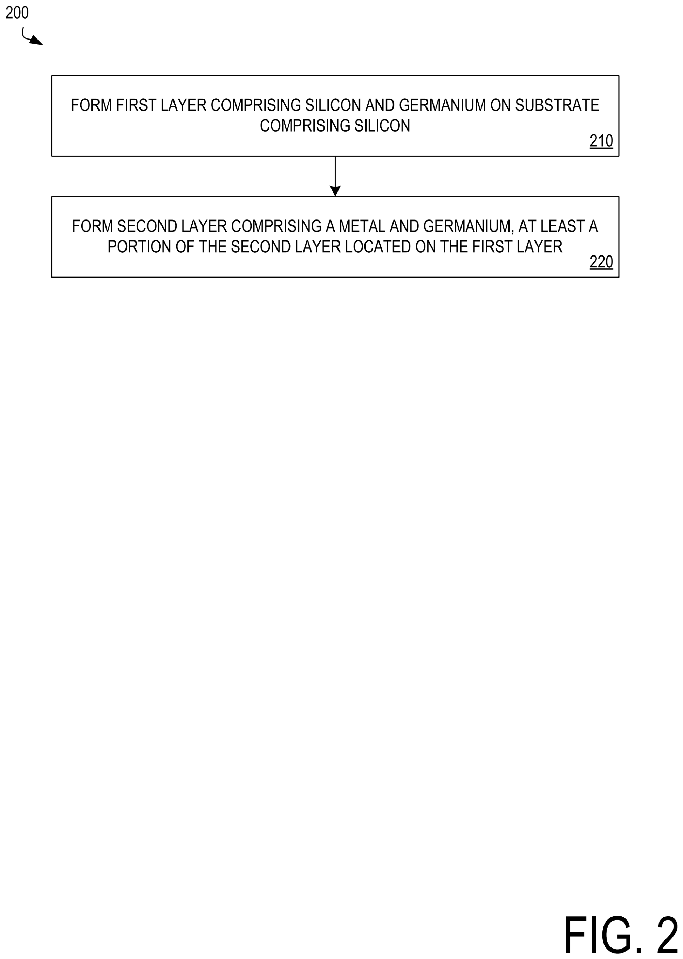

FIG. 2 is an example method of forming source and drain contacts with metal contact layers comprising germanium. The method 200 can be formed by, for example, an integrated circuit component manufacturer. At stage 210, a first layer comprising silicon and germanium is formed on a substrate comprising silicon. At stage 220, a second layer comprising a metal and germanium is formed, at least a portion of the second layer located on the first layer. In other embodiments, the method 200 can comprise additional stages. For example, the method 200 can further comprise forming a third layer located on the second layer, the third layer comprising tungsten, cobalt, titanium, gold, aluminum, molybdenum, chromium, or nickel. In another example, the method 200 can further comprise forming a fourth layer positioned between the second layer and the third layer, the fourth layer comprising titanium and nitrogen; indium and oxygen; tungsten and nitrogen; titanium and nitrogen; or ruthenium.

The contacts comprising metal contact layers with germanium described herein can be used in any processor unit, integrated circuit component, or computing system described or referenced herein. Such contacts can be fabricated as part of an integrated circuit structure. The integrated circuit structure can comprise a die substrate, such as a die substrate comprising silicon, and one or more interconnect or metal layers. Contacts formed as described herein can connect to a line of an interconnect or metal layer by a via or by being positioned adjacent to a line of a metal layer. The integrated circuit structure can comprise other types of devices, such as electronic transistors (transistors such as CMOS transistors that operate through control of the flow of electric current and that do not rely upon the switching of the magnetization of a layer or component for operation) and/or magnetoelectric spin-orbit (MESO) devices that use magnetoelectric switching to convert an input voltage/charge into a magnetic spin state (e.g., charge-to-spin conversion) and further uses spin-orbit transduction to convert the magnetic spin state back into an output charge/voltage (e.g., spin-to-charge conversion). An integrated circuit component comprising contacts formed as described herein can be attached to a printed circuit board. In some embodiments, one or more additional integrated circuit components can be attached to the circuit board, such as one or more additional integrated circuit components (e.g., processors, memory), battery, and/or antenna. In some embodiments, the printed circuit board and the integrated circuit component can be located in a computing device that comprises a housing that encloses the printed circuit board and the integrated circuit component.

It is to be understood that drawings illustrate idealized versions of structure lines. In actual lines, the lines, layers, and other elements illustrated in the drawings can have shapes that vary from those illustrated. For example, surfaces illustrated as planar possess undulations, bumps, or dishing features; sidewalls can have a taper to them; ninety-degree corners can be rounded; and lines, layers, and features can overlap more or less than illustrated.

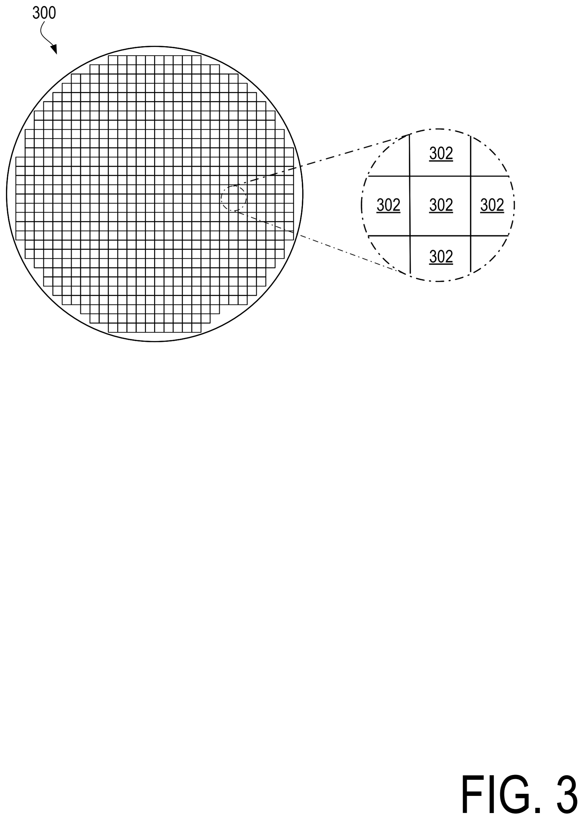

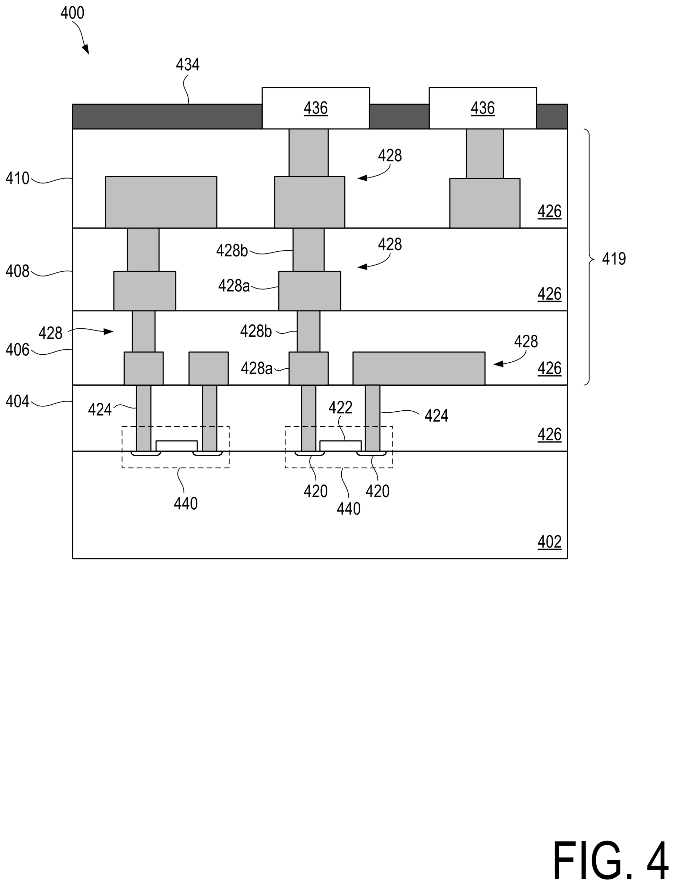

FIG. 3 is a top view of a wafer 300 and dies 302 in which any of the source or drain contacts comprising germanium disclosed herein may be included. The wafer 300 may be composed of semiconductor material and dies 302 having integrated circuit structures formed on a surface of the wafer 300. The individual dies 302 may be a repeating unit of an integrated circuit product that includes any suitable integrated circuit. After the fabrication of the semiconductor product is complete, the wafer 300 may undergo a singulation process in which the dies 302 are separated from one another to provide discrete "chips" of the integrated circuit product. The dies 302 may include one or more transistors (e.g., transistors 440 of FIG. 4, discussed below), supporting circuitry to route electrical signals to the transistors, passive components (e.g., signal traces, resistors, capacitors, or inductors), and/or any other integrated circuit components that can be fabricated on the wafer. In some embodiments, the wafer 300 or the dies 302 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), logic gates (e.g., AND, OR, NAND, and NOR gates), or any other suitable circuit element. Multiple ones of these devices and components may be combined on a single die. For example, a memory array formed by multiple memory devices may be formed on the same die as a processor unit or other logic configured to store information in the memory devices or execute instructions stored in the memory array.

FIG. 4 is a cross-sectional view of an integrated circuit structure 400 that may include any of the source or drain contacts comprising germanium disclosed herein. Multiple instances of the integrated circuit structure 400 may be included in the dies 302 (FIG. 3). The integrated circuit structure 400 may be formed on a die substrate 402. The die substrate 402 may be a semiconductor substrate composed of semiconductor material including, for example, n-type or p-type materials (or a combination of both). The die substrate 402 may include, for example, a crystalline substrate formed using a bulk silicon or a silicon-on-insulator (SOI) substructure. In some embodiments, the die substrate 402 can comprise a layer of silicon on top of an SOI layer with bulk silicon below the SOI layer. In some embodiments, the die substrate 402 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 402. Although a few examples of materials from which the die substrate 402 may be formed are described here, any material that may serve as a foundation for an integrated circuit structure 400 may be used. The die substrate 402 may be part of a singulated die (e.g., dies 302 of FIG. 3) or a wafer (e.g., wafer 300 of FIG. 3).

The integrated circuit structure 400 may include device layer 404 disposed on the die substrate 402. The device layer 404 may include features of transistors 440 (e.g., metal oxide semiconductor field-effect transistors (MOSFETs)) formed on the die substrate 402. The transistors 440 may include, for example, source and drain regions (S/D regions 420), a gate 422 to control current flow between the S/D regions 420, and S/D contacts 424 to route electrical signals to and from the S/D regions 420. The transistors 440 may include additional features not depicted for the sake of clarity, such as device isolation regions, gate contacts, and the like. The transistors 440 are not limited to the type and configuration depicted in FIG. 4 and may include a wide variety of other types and configurations such as, for example, non-planar transistors, or a combination of planar and non-planar transistors. Non-planar transistors may include FinFET transistors, such as double-gate transistors or tri-gate transistors, and wrap-around or all-around gate transistors, such as nanoribbon, nanosheet, or nanowire transistors.

FIGS. 5A-5D are perspective views of example planar, FinFET, gate-all-around, and stacked gate-all-around transistors. The transistors illustrated in FIGS. 5A-5D are formed on a substrate 516 having a substrate surface 508 and a bulk region 518. Isolation regions 514 separate the source and drain regions of the transistors from other transistors.

FIG. 5A is a perspective view of an example transistor 500 comprising a gate 502 that controls current flow between a source region 504 and a drain region 506. The transistor 500 is planar in that the source region 504, the drain region 506 and the substrate surface 508 lie in the same plane.

FIG. 5B is a perspective view of an example transistor 520 comprising a gate 522 that controls current flow between a source region 524 and a drain region 526. The transistor 520 is non-planar in that the source region 524 and the drain region 526 comprise "fins" that extend upwards from the substrate surface 508. The transistor 520 can be referred to as a FinFET. As the gate 522 encompasses three sides of the fin that extends from the source region 524 to the drain region 526, the transistor 520 can be considered a tri-gate transistor. FIG. 5B illustrates one S/D fin extending through the gate 522, but multiple S/D fins can extend through the gate of a FinFET transistor.

FIG. 5C is a perspective view of a transistor 540 comprising a gate 542 that controls current flow between a source region 544 and a drain region 546. The transistor 540 is non-planar in that the source region 544 and the drain region 546 lie in a different plane than the substrate surface 508. As the gate 542 encompasses all sides of the channel region of the transistor 540 that extends from the source region 544 to the drain region 546, the transistor 540 can be referred to as a gate-all-around (GAA) transistor.

FIG. 5D is a perspective view of a transistor 560 comprising a gate 562 that controls current flow between multiple elevated source regions 564 and multiple elevated drain regions 566. The transistor 560 is a stacked GAA transistor as the gate controls the flow of current between multiple elevated S/D regions stacked on top of each other. The transistors 540 and 560 are considered gate-all-around transistors as the gates encompass all sides of the channel regions of the transistor that extends from the source regions to the drain regions. The transistors 540 and 560 can alternatively be referred to as nanowire, nanosheet, or nanoribbon transistors depending on the width (e.g., widths 548 and 568 of transistors 540 and 560, respectively) of the channel regions extending through the gate.

Returning to FIG. 4, transistors 440 may include a gate 422 formed of at least two layers, a gate dielectric, and a gate electrode. The gate dielectric may include one or more layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For PMOS transistors, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For NMOS transistors, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, such as in the FinFET illustrated in FIG. 5B, the gate electrode may have an upside-down U-shape that includes a top portion substantially parallel to the surface of the die substrate 402 and two side portions that are substantially perpendicular to the top surface of the die substrate 402. In other embodiments, such as the planar FET illustrated in FIG. 5A, at least one of the metal layers that form the gate electrode may be a planar layer that is substantially parallel to the top surface of the die substrate 402 without side portions. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack (comprising the gate dielectric and the gate electrode) to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of sidewall spacer pairs may be used; for instance, two pairs, three pairs, or four pairs of sidewall spacers may be formed on opposing sides of the gate stack.

The S/D regions 420 may be formed within the die substrate 402 adjacent to the gate 422 of transistors 440. The S/D regions 420 may be formed using an implantation/diffusion process or an etching/deposition process, for example. In the former process, dopants such as boron, aluminum, antimony, phosphorous, or arsenic may be ion-implanted into the die substrate 402 to form the S/D regions 420. An annealing process that activates the dopants and causes them to diffuse further into the die substrate 402 may follow the ion implantation process. In the latter process, the die substrate 402 may first be etched to form recesses at the locations of the S/D regions 420. An epitaxial deposition process may then be carried out to fill the recesses with material that is used to fabricate the S/D regions 420. In some implementations, the S/D regions 420 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 420 may be formed using one or more alternate semiconductor materials such as germanium or a group III-V material or alloy. In further embodiments, one or more layers of metal and/or metal alloys may be used to form the S/D regions 420.

Electrical signals, such as power and/or information-carrying signals (e.g., input/output (I/O) signals, may be routed to and/or from devices (e.g., transistors 440) of the device layer 404 through one or more interconnect layers disposed on the device layer 404 (illustrated in FIG. 4 as interconnect layers 406-410). For example, electrically conductive features of the device layer 404 (e.g., the gate 422 and the S/D contacts 424) may be electrically coupled with interconnect structures 428 of the interconnect layers 406-410. The one or more interconnect layers 406-410 may form a metallization stack 419 (which can also be referred to as an "ILD stack" (inter-layer dielectric stack)) of the integrated circuit structure 400.

The interconnect structures 428 may be arranged within the interconnect layers 406-410 to route electrical signals according to a wide variety of designs; in particular, the arrangement is not limited to the particular configuration of interconnect structures 428 depicted in FIG. 4. Although a particular number of interconnect layers 406-410 is depicted in FIG. 4, embodiments of the present disclosure include integrated circuit structures having more or fewer interconnect layers than depicted.

In some embodiments, the interconnect structures 428 may include traces or lines 428a and/or vias 428b filled with an electrically conductive material such as a metal. The lines 428a may be arranged to route electrical signals in a direction of a plane that is substantially parallel with a surface of the die substrate 402 upon which the device layer 404 is formed. For example, the lines 428a may route electrical signals in a direction in and out of the page and/or in a direction across the page from the perspective of FIG. 4. The vias 428b may be arranged to route electrical signals in a direction of a plane that is substantially perpendicular to the surface of the die substrate 402 upon which the device layer 404 is formed. In some embodiments, lines 428a of different interconnect layers 406-410 are electrically coupled by vias 428b.

The interconnect layers 406-410 may include a dielectric material 426 within which the interconnect structures 428 are disposed, as shown in FIG. 4. In some embodiments, dielectric material 426 in different ones of the interconnect layers 406-410 may have different compositions; in other embodiments, the composition of the dielectric material 426 between different interconnect layers 406-410 may be the same. The device layer 404 may include a dielectric material 426 within which the transistors 440 are disposed and upon which a bottom layer of the metallization stack is located. The dielectric material 426 that is part of the device layer 404 may have a different composition than the dielectric material 426 included in the interconnect layers 406-410; in other embodiments, the composition of the dielectric material 426 in the device layer 404 may be the same as a dielectric material 426 included in any one of the interconnect layers 406-410.

A first interconnect layer 406 (which can be referred to as a Metal 1 or "M1" layer) may be formed directly on the device layer 404. In some embodiments, the first interconnect layer 406 may include lines 428a and/or vias 428b, as shown. The lines 428a of the first interconnect layer 406 may be coupled with contacts (e.g., the S/D contacts 424) of the device layer 404. The vias 428b of the first interconnect layer 406 may be coupled with the lines 428a of a second interconnect layer 408.

The second interconnect layer 408 (which can be referred to as a Metal 2 or "M2" layer) may be formed directly on the first interconnect layer 406. In some embodiments, the second interconnect layer 408 may include vias 428b to couple the lines 428a of the second interconnect layer 408 with the lines 428a of a third interconnect layer 410. Although the lines 428a and the vias 428b are structurally delineated with a line within individual interconnect layers for the sake of clarity, the lines 428a and the vias 428b may be structurally and/or materially contiguous (e.g., simultaneously filled during a dual-damascene process) in some embodiments.

The third interconnect layer 410 (which can be referred to as a Metal 3 or "M3" layer) (and additional interconnect layers, as desired) may be formed in succession on the second interconnect layer 408 according to similar techniques and configurations described in connection with the second interconnect layer 408 or the first interconnect layer 406. In some embodiments, the interconnect layers that are "higher up" in the metallization stack 419 in the integrated circuit structure 400 (i.e., farther away from the device layer 404) may be thicker than the interconnect layers that are lower in the metallization stack 419, with lines 428a and vias 428b in the higher interconnect layers being thicker than those in the lower interconnect layers.

The integrated circuit structure 400 may include a solder resist material 434 (e.g., polyimide or similar material) and conductive contacts 436 formed on the stack of interconnect layers 406-410. In FIG. 4, the conductive contacts 436 are illustrated as taking the form of bond pads. The conductive contacts 436 may be electrically coupled with interconnect structures 428 of the top-most layer in the metallization stack 419 and configured to route electrical signals between the transistors 440 and components external to the integrated circuit structure 400. For example, solder bonds may be formed on the conductive contacts 436 to mechanically and/or electrically couple an integrated circuit component comprising the integrated circuit structure 400 with another component (e.g., a printed circuit board). The integrated circuit structure 400 may include additional or alternate structures to route electrical signals from the interconnect layers 406-410; for example, the conductive contacts 436 may include other analogous features (e.g., posts) that can route the electrical signals between the transistors 440 and external components.

In some embodiments in which the integrated circuit structure 400 is part of a double-sided die, the integrated circuit structure 400 may include a second metallization stack (not shown) located on the opposite side of the die substrate 402 from the device layer 404. This second metallization stack may include multiple interconnect layers as discussed above with reference to the interconnect layers 406-410. Through-silicon vias (TSVs) that extend through the die substrate 402 can provide electrically conductive pathways from the transistors 440 to the second metallization stack and the second metallization stack can electrically couple the TSVs to additional conductive contacts (not shown) located on the opposite side of the integrated circuit structure 400 from the conductive contacts 436.

In some embodiments, TSVs extending through the die substrate 402 can be used for routing power and ground signals from conductive contacts located on the opposite side of the integrated circuit structure 400 from the conductive contacts 436 to the transistors 440 and any other components integrated into the integrated circuit structure 400, and the metallization stack 419 can be used to route information-carrying signals from the conductive contacts 436 to transistors 440 and any other components integrated into the integrated circuit structure 400. Put another way, the routing of power and ground signals to the transistors 440 can be separated (via a back-side or bottom-side metallization stack and TSVs) from the routing of information-carrying signals to the transistors. The power and ground signals are provided by a back-side or bottom-side metallization stack and TSVs, and information-carrying signals are provided by a top-side metallization stack (e.g., metallization stack 419).

Several integrated circuit dies may be stacked with one or more TSVs in the individual stacked dies providing connection between one of the dies to any of the other dies in the stack. For example, one or more high-bandwidth memory (HBM) integrated circuit dies can be stacked on top of a base integrated circuit die and TSVs in the HBM dies can provide connection between the individual HBM dies and the base integrated circuit die. Conductive contacts can provide additional connections between adjacent integrated circuit dies in the stack. In some embodiments, the conductive contacts can be fine-pitch solder bumps (microbumps).

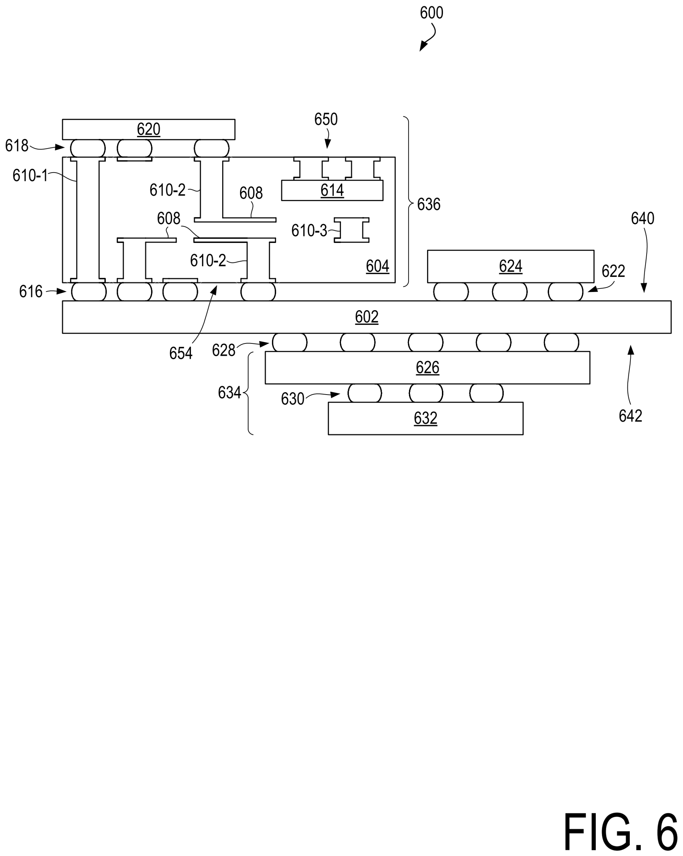

FIG. 6 is a cross-sectional view of an integrated circuit device assembly 600 that may include any of the contacts comprising a metal contact layer comprising germanium disclosed herein. The integrated circuit device assembly 600 includes a number of components disposed on a circuit board 602 (which may be a motherboard, system board, mainboard, etc.). The integrated circuit device assembly 600 includes components disposed on a first face 640 of the circuit board 602 and a second face 642 of the circuit board 602, the second face 642 opposing the first face 640. Generally, components may be disposed on either or both of the first face 640 and the second face 642 of the circuit board 602.

In some embodiments, the circuit board 602 may be a printed circuit board (PCB) including multiple metal (or interconnect) layers separated from one another by layers of dielectric material and interconnected by electrically conductive vias. The individual metal layers comprise conductive traces. The metal layers may be formed in a desired pattern to route electrical signals between the components electrically coupled to the circuit board 602. In other embodiments, the circuit board 602 may be a non-PCB substrate.

The integrated circuit device assembly 600 illustrated in FIG. 6 includes a package-on-interposer structure 636 coupled to the first face 640 of the circuit board 602 by coupling components 616. The coupling components 616 may electrically and mechanically couple the package-on-interposer structure 636 to the circuit board 602 and may include solder balls (as shown in FIG. 6), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. (Thus, a coupling component may comprise a conductive contact.)

The package-on-interposer structure 636 may include an integrated circuit component 620 coupled to an interposer 604. The interposer 604 may provide an intervening substrate used to bridge the circuit board 602 and the integrated circuit component 620. The integrated circuit component 620 is coupled to the interposer 604 by coupling components 618. The coupling components 618 may take any suitable form, such as the forms discussed above with reference to the coupling components 616. Although FIG. 6 shows just one integrated circuit component attached to the interposer, multiple integrated circuit components may be coupled to the interposer 604. Additional interposers may be coupled to the interposer 604.

The integrated circuit component 620 may be a packaged or unpacked integrated circuit product that includes one or more integrated circuit dies (e.g., the die 302 of FIG. 3, a die comprising the integrated circuit structure 400 of FIG. 4) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one unpackaged example of an integrated circuit component 620, a single monolithic integrated circuit die comprises solder bumps attached to contacts on the die. The solder bumps allow the die to be directly attached to the interposer 604. The integrated circuit component 620 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 620 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 620 comprises multiple integrated circuit dies, the dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 620 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 604 may spread connections to a wider or narrower pitch or reroute a connection to a different connection. For example, the interposer 604 may couple coupling components 618 having a first pitch to coupling components 616 having a wider pitch than the first pitch. In the embodiment illustrated in FIG. 6, the integrated circuit component 620 and the circuit board 602 are attached to opposing sides of the interposer 604. In other embodiments, the integrated circuit component 620 and the circuit board 602 may be attached to a same side of the interposer 604. In some embodiments, three or more components may be interconnected by way of the interposer 604.

In some embodiments, the interposer 604 may be formed as a PCB, including multiple metal layers separated from one another by layers of dielectric material and interconnected by electrically conductive vias. In some embodiments, the interposer 604 may be formed of an epoxy resin, a fiberglass-reinforced epoxy resin, an epoxy resin with inorganic fillers, a ceramic material, or a polymer material such as polyimide. In some embodiments, the interposer 604 may be formed of alternate rigid or flexible materials that may include the same materials described above for use in a semiconductor substrate, such as silicon, germanium, and other group III-V and group IV materials. The interposer 604 may include metal interconnects 608 and vias, including but not limited to through hole vias 610-1 (that extend from a first face 650 of the interposer 604 to a second face 654 of the interposer 604), blind vias 610-2 (that extend from the first face 650 or the second face 654 of the interposer 604 to an internal metal layer), and buried vias 610-3 (that connect internal metal layers).

In some embodiments, the interposer 604 can comprise a silicon interposer. Through silicon vias (TSV) extending through the silicon interposer can connect connections on a first face of a silicon interposer to an opposing second face of the silicon interposer. In some embodiments, an interposer 604 comprising a silicon interposer can further comprise one or more routing layers to route connections on a first face of the interposer 604 to an opposing second face of the interposer 604.

The interposer 604 may further include embedded devices 614, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 604. The package-on-interposer structure 636 may take the form of any of the package-on-interposer structures known in the art.

The integrated circuit device assembly 600 may include an integrated circuit component 624 coupled to the first face 640 of the circuit board 602 by coupling components 622. The coupling components 622 may take the form of any of the embodiments discussed above with reference to the coupling components 616, and the integrated circuit component 624 may take the form of any of the embodiments discussed above with reference to the integrated circuit component 620.

The integrated circuit device assembly 600 illustrated in FIG. 6 further includes a package-on-package structure 634 coupled to the second face 642 of the circuit board 602 by coupling components 628. The package-on-package structure 634 may include an integrated circuit component 626 and an integrated circuit component 632 coupled together by coupling components 630 such that the integrated circuit component 626 is disposed between the circuit board 602 and the integrated circuit component 632. The coupling components 628 and 630 may take the form of any of the embodiments of the coupling components 616 discussed above, and the integrated circuit components 626 and 632 may take the form of any of the embodiments of the integrated circuit component 620 discussed above. The package-on-package structure 634 may be configured in accordance with any of the package-on-package structures known in the art.

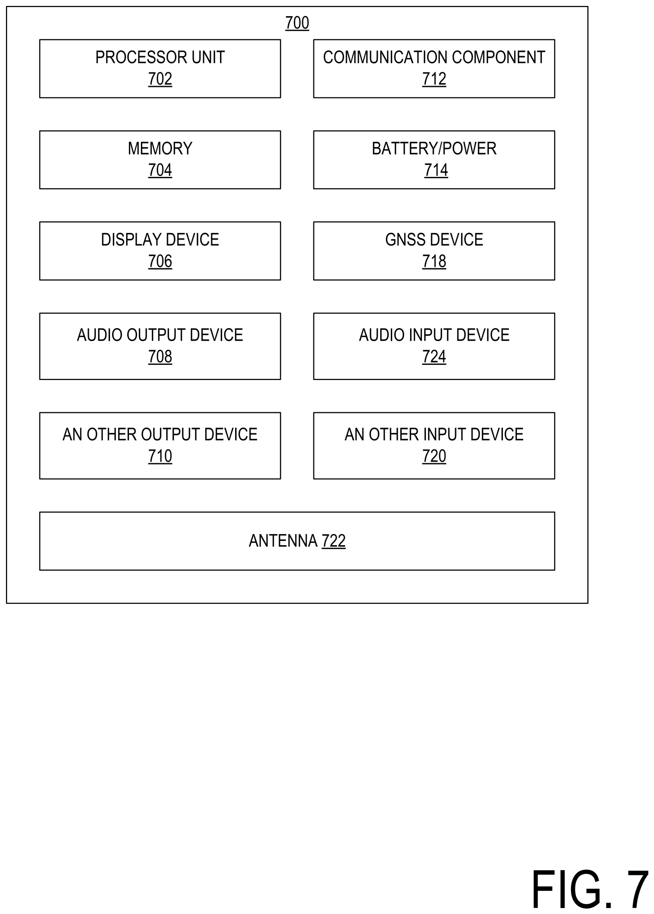

FIG. 7 is a block diagram of an example electrical device 700 that may include any of the contacts comprising a metal contact layer comprising germanium disclosed herein. For example, any suitable ones of the components of the electrical device 700 may include one or more of the integrated circuit device assembly 600, integrated circuit component 620, or integrated circuit structure 400, integrated circuit dies 302 disclosed herein, and may be arranged in any of the microelectronic assemblies disclosed herein. A number of components are illustrated in FIG. 7 as included in the electrical device 700, but any one or more of these components may be omitted or duplicated, as suitable for the application. In some embodiments, some or all of the components included in the electrical device 700 may be attached to one or more motherboards mainboards, or system boards. In some embodiments, one or more of these components are fabricated onto a single system-on-a-chip (SoC) die.

Additionally, in various embodiments, the electrical device 700 may not include one or more of the components illustrated in FIG. 7, but the electrical device 700 may include interface circuitry for coupling to the one or more components. For example, the electrical device 700 may not include a display device 706, but may include display device interface circuitry (e.g., a connector and driver circuitry) to which a display device 706 may be coupled. In another set of examples, the electrical device 700 may not include an audio input device 724 or an audio output device 708, but may include audio input or output device interface circuitry (e.g., connectors and supporting circuitry) to which an audio input device 724 or audio output device 708 may be coupled.

The electrical device 700 may include one or more processor units 702. As used herein, the terms "processor unit," "processing unit," or "processor" may refer to any device or portion of a device that processes electronic data from registers and/or memory to transform that electronic data into other electronic data that may be stored in registers and/or memory. The one or more processor units 702 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 700 may include a memory 704, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 704 may include memory that is located on the same integrated circuit die as the one or more processor units 702. This memory may be used as cache memory (e.g., Level 1 (L1), Level 2 (L2), Level 3 (L3), Level 4 (L4), Last Level Cache (LLC)) and may include embedded dynamic random-access memory (eDRAM) or spin transfer torque magnetic random-access memory (STT-MRAM).

In some embodiments of the electrical device 700, a first one of the one or more processor units 702 can be heterogeneous or asymmetric to a second one of the one or more processor units 702 in the electrical device 700. There can be a variety of differences between the one or more processor units 702 in a system in terms of a spectrum of metrics of merit including architectural, microarchitectural, thermal, power consumption characteristics, and the like. These differences can effectively manifest themselves as asymmetry and heterogeneity among the one or more processor units 702 in the electrical device 700.

In some embodiments, the electrical device 700 may include a communication component 712. For example, the communication component 712 can manage wireless communications for the transfer of data to and from the electrical device 700. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 712 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 712 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 712 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 712 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 712 may operate in accordance with other wireless protocols in other embodiments. The electrical device 700 may include an antenna 722 to facilitate wireless communications and/or to receive other wireless communications (such as AM or FM radio transmissions).

In some embodiments, the communication component 712 may manage wired communications, such as electrical, optical, or any other suitable communication protocols (e.g., IEEE 802.3 Ethernet standards). In some embodiments, the electrical device 700 comprises multiple communication components. For instance, a first communication component may be dedicated to shorter-range wireless communications such as Wi-Fi or Bluetooth, and a second communication component may be dedicated to longer-range wireless communications such as global positioning system (GPS), EDGE, GPRS, CDMA, WiMAX, LTE, EV-DO, or others. In some embodiments, a first communication component may be dedicated to wireless communications, and a second communication component may be dedicated to wired communications.

The electrical device 700 may include battery/power circuitry 714. The battery/power circuitry 714 may include one or more energy storage devices (e.g., batteries or capacitors) and/or circuitry for coupling components of the electrical device 700 to an energy source separate from the electrical device 700 (e.g., AC line power).

The electrical device 700 may include a display device 706 (or corresponding interface circuitry, as discussed above). The display device 706 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 700 may include an audio output device 708 (or corresponding interface circuitry, as discussed above). The audio output device 708 may include any embedded or wired or wirelessly connected external device that generates an audible indicator, such as speakers, headsets, or earbuds.

The electrical device 700 may include an audio input device 724 (or corresponding interface circuitry, as discussed above). The audio input device 724 may include any embedded or wired or wirelessly connected device that generates a signal representative of a sound, such as microphones, microphone arrays, or digital instruments (e.g., instruments having a musical instrument digital interface (MIDI) output). The electrical device 700 may include a Global Navigation Satellite System device (GNSS) (or corresponding interface circuitry, as discussed above), such as a Global Positioning System (GPS) device. The GNSS device 718 may be in communication with a satellite-based system and may determine a geolocation of the electrical device 700 based on information received from one or more GNSS satellites, as known in the art.

The electrical device 700 may include another output device 710 (or corresponding interface circuitry, as discussed above). Examples of the other output device 710 may include an audio codec, a video codec, a printer, a wired or wireless transmitter for providing information to other devices, or an additional storage device.

The electrical device 700 may include another input device 720 (or corresponding interface circuitry, as discussed above). Examples of the other input device 720 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 700 may have any form factor, such as a hand-held or mobile electrical device (e.g., a cell phone, a smartphone, a mobile internet device, a music player, a tablet computer, a laptop computer, a 2-in-1 convertible computer, a portable all-in-one computer, a netbook computer, an ultrabook computer, a personal digital assistant (PDA), an ultra-mobile personal computer, a portable gaming console), a desktop electrical device, a server, a rack-level computing solution (e.g., blade, tray, or sled computing system), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 700 may be any other electronic device that processes data. In some embodiments, the electrical device 700 may comprise multiple discrete physical components. Given the range of devices that the electrical device 700 can be manifested as in various embodiments, in some embodiments, the electrical device 700 can be referred to as a computing device or a computing system.

As used in this application and the claims, a list of items joined by the term "and/or" can mean any combination of the listed items. For example, the phrase "A, B, and/or C" can mean A; B; C; A and B; A and C; B and C; or A, B and C. As used in this application and the claims, a list of items joined by the term "at least one of" can mean any combination of the listed terms. For example, the phrase "at least one of A, B, or C" can mean A; B; C; A and B; A and C; B and C; or A, B, and C. Moreover, as used in this application and the claims, a list of items joined by the term "one or more of" can mean any combination of the listed terms. For example, the phrase "one or more of A, B, and C" can mean A; B; C; A and B; A and C; B and C; or A, B, and C.

The disclosed methods, apparatuses, and systems are not to be construed as limiting in any way. Instead, the present disclosure is directed toward all novel and nonobvious features and aspects of the various disclosed embodiments, alone and in various combinations and subcombinations with one another. The disclosed methods, apparatuses, and systems are not limited to any specific aspect or feature or combination thereof, nor do the disclosed embodiments require that any one or more specific advantages be present or problems be solved.

Theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

Although the operations of some of the disclosed methods are described in a particular, sequential order for convenient presentation, it is to be understood that this manner of description encompasses rearrangement, unless a particular ordering is required by specific language set forth herein. For example, operations described sequentially may in some cases be rearranged or performed concurrently. Moreover, for the sake of simplicity, the attached figures may not show the various ways in which the disclosed methods can be used in conjunction with other methods.

The following examples pertain to additional embodiments of technologies disclosed herein.

Example 1 comprises an apparatus, comprising: a substrate comprising silicon; a first layer comprising silicon and germanium, the first layer located on the substrate; and a second layer comprising a metal and germanium, at least a portion of the second layer located on the first layer, wherein: a maximum atomic percentage of germanium in the first layer taken along a line from an interface between the first layer and the second layer to a point about 20 nanometers into the first layer is a first atomic percentage of germanium; an atomic percentage of germanium in the first layer at the interface is a second atomic percentage of germanium; and the second atomic percentage of germanium is no less than 50% of the first atomic percentage.

Example 2 comprises the apparatus of Example 1, wherein the second atomic percentage of germanium is no less than 80% of the first atomic percentage of germanium.

Example 3 comprises the apparatus of Example 1 or 2, wherein the second atomic percentage of germanium is greater than about 5.0 x 1021 cm-3.

Example 4 comprises the apparatus of Example 1 or 2, wherein the second atomic percentage of germanium is greater than about 7.5 x 1021 cm-3.

Example 5 comprises the apparatus of Example 1 or 2, wherein the second atomic percentage of germanium is greater than about 1.0 x 1022 cm-3.

Example 6 comprises an apparatus, comprising: a substrate comprising silicon; a first layer located on the substrate, the first layer comprising silicon and germanium; and a second layer comprising a metal and germanium located on the first layer, a portion of the second layer located on the first layer, wherein a minimum atomic percentage of germanium in the first layer and the second layer taken along a line from a point about three nanometers into the first layer from an interface between the first layer and the second layer to a point about three nanometers into the second layer from the interface is within an order of magnitude of a maximum atomic percentage of germanium taken along the line.

Example 7 comprises the apparatus of Example 6, wherein the minimum atomic percentage of germanium taken along the line is no less than about 50% of the maximum atomic percentage of germanium taken along the line.

Example 8 comprises the apparatus of Example 6, wherein the minimum atomic percentage of germanium taken along the line is no less than about 80% of the maximum atomic percentage of germanium taken along the line.

Example 9 comprises the apparatus of Example 6, wherein the line is a first line and a minimum atomic percentage of germanium in the first layer and the second layer taken along a second line from a point about five nanometers into the first layer from the interface to a point about five nanometers into the second layer from the interface is within an order of magnitude of a maximum atomic percentage of germanium taken along the second line.

Example 10 comprises the apparatus of Example 9, wherein the minimum atomic percentage of germanium taken along the second line is no less than about 50% of the maximum atomic percentage of germanium taken along the second line.

Example 11 comprises the apparatus of Example 9, wherein the minimum atomic percentage of germanium taken along the second line is no less than about 80% of the maximum atomic percentage of germanium taken along the second line.

Example 12 comprises the apparatus of any one of Examples 1-11, wherein an atomic percentage of germanium in the second layer at the interface between the first layer and the second layer is greater than about 5% and less than about 80%.

Example 13 comprises the apparatus of any one of Examples 1-11, wherein the line is a first line and a minimum atomic percentage of germanium in the second layer taken along a second line from the interface to a face of the second layer located opposite to the interface is greater than about 50% of a maximum atomic percentage of germanium in the second layer taken along the second line.

Example 14 comprises the apparatus of any one of Examples 1-11, wherein the line is a first line and a minimum atomic percentage of germanium in the second layer taken along a second line from the interface to a face of the second layer located opposite to the interface is greater than about 80% of a maximum atomic percentage of germanium in the second layer taken along the second line.

Example 15 comprises the apparatus of any one of Examples 1-11, wherein the line is a first line and a minimum atomic percentage of germanium in the second layer taken along a second line from the interface to a face of the second layer located opposite to the interface is within an order of magnitude of a maximum atomic percentage of germanium in the second layer taken along the second line.

Example 16 comprises the apparatus of any one of Examples 1-15, wherein the first layer and the second layer further comprises boron.

Example 17 comprises the apparatus of any one of Examples 1-15, wherein the first layer further comprises gallium or indium.

Example 18 comprises the apparatus of any one of Examples 1-17 wherein a thickness of the second layer is about 10 nanometers or less.

Example 19 comprises the apparatus of any one of Examples 1-18 wherein the metal comprises titanium or molybdenum.

Example 20 comprises the apparatus of any one of Examples 1-18, wherein the metal comprises tantalum, niobium, tungsten, nickel, ruthenium, platinum, gold, palladium, or iridium.

Example 21 comprises the apparatus of any one of Examples 1-20, further comprising a third layer located on the second layer, the third layer comprising tungsten, cobalt, titanium, gold, aluminum, molybdenum, chromium, or nickel.

Example 22 comprises the apparatus of Example 21, further comprising a fourth layer positioned between the second layer and the third layer, the fourth layer comprising titanium and nitrogen.

Example 23 comprises the apparatus of Example 21, further comprising a fourth layer positioned between the second layer and the third layer, the fourth layer comprising: indium and oxygen; tungsten and nitrogen; titanium and nitrogen; or ruthenium.

Example 24 comprises the apparatus of any one of Examples 1-23, wherein the first layer is a source or drain region of a transistor.

Example 25 comprises the apparatus of Example 24, wherein the transistor is a planar field-effect transistor (FET), a FinFET, a gate-all-around FET (GAAFET), or a stacked gate-all-around FET.

Example 26 comprises the apparatus of any one of Examples 1-25, wherein the apparatus is an integrated circuit component.

Example 27 comprises the apparatus of Example 26, wherein the integrated circuit component is attached to a printed circuit board.

Example 28 comprises the apparatus of Example 27, wherein the integrated circuit component is a first integrated circuit component, the apparatus further comprising a second integrated circuit component, battery, and/or antenna attached to the printed circuit board.

Example 29 comprises the apparatus of any one of Examples 26-28 further comprising a housing that is part of a computing system, wherein the integrated circuit component is located within the housing.

Example 30 comprises the apparatus of any one of Examples 1-29, wherein the first layer is an epitaxial layer.

Example 31 comprises a system comprising: an integrated circuit component comprising: a substrate comprising silicon; a first layer located on the substrate, the first layer comprising silicon and germanium, the first layer a source or drain region of a p-channel metal-oxide-semiconductor (PMOS) field effect transistor; and a second layer comprising a metal and germanium located on the first layer, a portion of the second layer located on the first layer, wherein a minimum atomic percentage of germanium in the first layer and the second layer taken along a line from a point about five nanometers into the first layer from an interface between the first layer and the second layer to a point about five nanometers into the second layer from the interface is within an 50% of a maximum atomic percentage of germanium taken along the line; and a printed circuit board, the integrated circuit component attached to the printed circuit board.

Example 32 comprises the system of Example 31, wherein the minimum atomic percentage of germanium taken along the line is no less than about 50% of the maximum atomic percentage of germanium taken along the line.

Example 33 comprises the system of Example 31, wherein the minimum atomic percentage of germanium taken along the line is no less than about 80% of the maximum atomic percentage of germanium taken along the line.

Example 34 comprises the system of any one of Examples 31-33, wherein an atomic percentage of germanium in the second layer at the interface between the first layer and the second layer is greater than about 5% and less than about 80%.

Example 35 comprises the system of any one of Examples 31-33, wherein the line is a first line and a minimum atomic percentage of germanium in the second layer taken along a second line from the interface to a face of the second layer located opposite to the interface is greater than about 50% of a maximum atomic percentage of germanium in the second layer taken along the second line.

Example 36 comprises the system of any one of Examples 31-33, wherein the line is a first line and a minimum atomic percentage of germanium in the second layer taken along a second line from the interface to a face of the second layer located opposite to the interface is greater than about 80% of a maximum atomic percentage of germanium in the second layer taken along the second line.

Example 37 comprises the system of any one of Examples 31-33, wherein the line is a first line and a minimum atomic percentage of germanium in the second layer taken along a second line from the interface to a face of the second layer located opposite to the interface is within an order of magnitude of a maximum atomic percentage of germanium in the second layer taken along the second line.

Example 38 comprises the system of any one of Examples 31-37, wherein the first layer and the second layer further comprises boron.

Example 39 comprises the system of any one of Examples 31-37, wherein the first layer further comprises gallium or indium.

Example 40 comprises the system of any one of Examples 31-39, wherein a thickness of the second layer is about 10 nanometers or less.

Example 41 comprises the system of any one of Examples 31-40 wherein the metal comprises titanium or molybdenum.

Example 42 comprises the system of any one of Examples 31-40, wherein the metal comprises tantalum, niobium, tungsten, nickel, ruthenium, platinum, gold, palladium, or iridium.

Example 43 comprises the system of any one of Examples 31-42, further comprising a third layer located on the second layer, the third layer comprising tungsten, cobalt, titanium, gold, aluminum, molybdenum, chromium, or nickel.

Example 44 comprises the system of Example 43, further comprising a fourth layer positioned between the second layer and the third layer, the fourth layer comprising titanium and nitrogen.

Example 45 comprises the system of Example 43, further comprising a fourth layer positioned between the second layer and the third layer, the fourth layer comprising: indium and oxygen; tungsten and nitrogen; titanium and nitrogen; or ruthenium.

Example 46 comprises the system of Example 31, wherein the transistor is a planar field-effect transistor (FET), a FinFET, a gate-all-around FET (GAAFET), or a stacked gate-all-around FET.

Example 47 comprises the system of Example 31, wherein the integrated circuit component is a first integrated circuit component, the system further comprising a second integrated circuit component, battery, and/or antenna attached to the printed circuit board.

Example 48 comprises the system of any one of Examples 31-47 further comprising a housing that is part of a computing system, wherein the integrated circuit component is located within the housing.

Example 49 comprises a method, comprising: forming a first layer comprising silicon and germanium, the first layer located on a substrate comprising silicon; and forming a second layer comprising a metal and germanium, at least a portion of the second layer located on the first layer.

Example 50 comprises the method of Example 49, wherein forming the second layer comprises: forming a first sub-layer of the second layer comprising germanium and the metal; and forming a second sub-layer of the second layer comprising the metal and not comprising germanium.

Example 51 comprises the method of Example 49, wherein forming the second layer comprises sputtering a target to form the second layer, the target comprising the metal.

Example 52 comprises the method of Example 51, wherein the target further comprises germanium, the target comprising about 10% to about 50% germanium by weight.

Example 53 comprises the method of Example 51 or 52, wherein the target further comprises boron.

Example 54 comprises the method of Example 51, wherein the target comprises from 5% to about 50% boron by weight.

Example 55 comprises the method of Example 51, wherein the target comprises from 5% to about 20% boron by weight.

Example 56 comprises the method of Example 49, wherein the second layer is formed by co-sputtering a first target comprising the metal and a second target comprising germanium.

Example 57 comprises the method of Example 56, wherein the first target or the second target comprises at least 50% boron by weight.

Example 58 comprises the method of Example 56, wherein forming the second layer comprises: co-sputtering the first target and the second target to form a first sub-layer of the second layer; and sputtering the first target to form a second sub-layer of the second layer.

Example 59 comprises the method of Example 49, wherein the second layer is formed via atomic layer deposition.

Example 60 comprises the method of Example 59, wherein forming the second layer comprises alternately forming one or more first sub-layers of the second layer comprising germanium with one or more second sub-layers of the second layer comprising the metal and not comprising germanium.

Example 61 comprises the method of Example 49, wherein the second layer is formed via a chemical vapor deposition process.

Example 62 comprises the method of Example 61, wherein: during a first phase of the chemical vapor deposition process, the second layer is formed with a first atomic percentage of germanium; and during a second phase of the chemical vapor deposition process, the second layer is formed with no germanium or a second atomic percentage of germanium that is less than the first atomic percentage of germanium.

Example 63 comprises the method of any one of Examples 49-62, wherein the first layer comprises boron.

Example 64 comprises the method of any one of Examples 49-63, wherein a thickness of the second layer is about 10 nanometers or less.

Example 65 comprises the method of any one of Examples 49-64, wherein the metal comprises titanium or molybdenum.

Example 66 comprises the method of any one of Examples 49-65, wherein the metal comprises tantalum, niobium, tungsten, nickel, ruthenium, platinum, gold, palladium, or iridium.

Example 67 comprises the method of any one of Examples 49-66, wherein the second layer further comprises boron.

Example 68 comprises the method of any one of Examples 49-67, further comprising forming a third layer located on the second layer, the third layer comprising tungsten, cobalt, titanium, gold, aluminum, molybdenum, chromium, or nickel.

Example 69 comprises the method of Example 68, further comprising forming a fourth layer positioned between the second layer and the third layer, the fourth layer comprising titanium and nitrogen.

Example 70 comprises the method of Example 68, further comprising forming a fourth layer positioned between the second layer and the third layer, the fourth layer comprising: indium and oxygen; tungsten and nitrogen; titanium and nitrogen; or ruthenium.

Example 71 comprises the method of any one of Examples 49-70, wherein the first layer is a source region or a drain region of a transistor.

Example 72 comprises the method of any one of Examples 49-71, wherein the first layer is an epitaxial layer.

Example 73 comprises the method of any one of Examples 49-71, wherein the substrate is a wafer.

Example 74 comprises the apparatus of any one of Examples 1-30, wherein a maximum atomic percentage of germanium in the second layer taken along a line across the metal contact layer is greater than the first atomic percentage of germanium.

Example 75 comprises the system of any one of Examples 31-48, wherein a maximum atomic percentage of germanium in the second layer taken along a line across the metal contact layer is greater than a maximum atomic percentage of germanium taken along a line from the interface between the first layer and the second layer.

## Claims

1. An apparatus, comprising:
a substrate comprising silicon;
a first layer comprising silicon and germanium, the first layer located on the substrate; and
a second layer comprising a metal and germanium, at least a portion of the second layer located on the first layer, wherein:
a maximum atomic percentage of germanium in the first layer taken along a line from an interface between the first layer and the second layer to a point about 20 nanometers into the first layer is a first atomic percentage of germanium;
an atomic percentage of germanium in the first layer at the interface is a second atomic percentage of germanium; and
the second atomic percentage of germanium is no less than 50% of the first atomic percentage.

2. The apparatus of claim 1, wherein the second atomic percentage of germanium is no less than 80% of the first atomic percentage of germanium.

3. The apparatus of claim 1 or 2, wherein the second atomic percentage of germanium is greater than about 5.0 x 10²¹ cm³.

4. The apparatus of any one of claims 1-3, wherein the line is a first line and a minimum atomic percentage of germanium in the second layer taken along a second line from the interface to a face of the second layer located opposite to the interface is within an order of magnitude of a maximum atomic percentage of germanium in the second layer taken along the second line.

5. The apparatus of any one of claims 1-4, wherein a thickness of the second layer is about 10 nanometers or less.

6. The apparatus of any one of claims 1-5, wherein the metal comprises titanium, molybdenum, tantalum, niobium, tungsten, nickel, ruthenium, platinum, gold, palladium, or iridium.

7. The apparatus of any one of claims 1-6, further comprising a third layer located on the second layer, the third layer comprising tungsten, cobalt, titanium, gold, aluminum, molybdenum, chromium, or nickel.

8. The apparatus of any one of claims 1-7, wherein the first layer is a source or drain region of a transistor.

9. The apparatus of any one of claims 1-8, wherein an atomic percentage of germanium in the second layer at the interface between the first layer and the second layer is greater than about 5% and less than about 80%.

10. The apparatus of any one of claims 1-9, wherein the line is a first line and a minimum atomic percentage of germanium in the second layer taken along a second line from the interface to a face of the second layer located opposite to the interface is greater than about 50% of a maximum atomic percentage of germanium in the second layer taken along the second line.

11. The apparatus of any one of claims 1-10, wherein the line is a first line and a minimum atomic percentage of germanium in the second layer taken along a second line from the interface to a face of the second layer located opposite to the interface is greater than about 80% of a maximum atomic percentage of germanium in the second layer taken along the second line.

12. The apparatus of any one of claims 1-11, wherein the line is a first line and a minimum atomic percentage of germanium in the second layer taken along a second line from the interface to a face of the second layer located opposite to the interface is within an order of magnitude of a maximum atomic percentage of germanium in the second layer taken along the second line.

13. The apparatus of any one of claims 1-12, wherein the first layer and the second layer further comprises boron.

14. The apparatus of any one of claims 1-13, wherein the apparatus further comprises:
an integrated circuit component, the integrated circuit component comprising the substrate, the first layer, and the second layer; and
a printed circuit board, the integrated circuit component attached to the printed circuit board.

15. The apparatus of claim 14, further comprising a second integrated circuit component, battery, and/or antenna attached to the printed circuit board.
